Europäisches Patentamt

European Patent Office

Office européen des brevets

(19)

(11) Numéro de publication: **0 244 322 B1**

(12) **FASCICULE DE BREVET EUROPEEN**

(45) Date de publication de fascicule du brevet:
12.06.91

(51) Int. Cl.⁵: **H01L 21/56**

(21) Numéro de dépôt: **87400986.3**

(22) Date de dépôt: **29.04.87**

Jointe à la demande no. 87902560.9/0264416
(numéro de dépôt/numéro de publication de la
demande européenne) par décision du 19.11.90.

(54) **Procédé d'encapsulation de circuits intégrés.**

(30) Priorité: **30.04.86 FR 8606333**

(43) Date de publication de la demande:
**04.11.87 Bulletin 87/45**

(45) Mention de la délivrance du brevet:
**12.06.91 Bulletin 91/24**

(84) Etats contractants désignés:
**AT BE CH DE ES FR GB GR IT LI LU NL SE**

(56) Documents cités:
**EP-A- 0 110 518**
**FR-A- 2 390 008**
**FR-A- 2 520 541**
**GB-A- 2 164 794**

(73) Titulaire: **SGS-THOMSON MICROELECTRO-
NICS S.A.**
**101 Boulevard Murat**
**F-75016 Paris(FR)**

(72) Inventeur: **Labelle, Jean**
**THOMSON-CSF SCPI 19, avenue de Messine**
**F-75008 Paris(FR)**
Inventeur: **Steffen, Francis**
**THOMSON-CSF SCPI 19, avenue de Messine**
**F-75008 Paris(FR)**

(74) Mandataire: **Guérin, Michel et al**
**THOMSON-CSF SCPI**
**F-92045 PARIS LA DEFENSE CEDEX 67(FR)**

EP 0 244 322 B1

## Description

La présente invention concerne un procédé d'encapsulation de circuits intégrés.

Certains utilisateurs de circuits intégrés souhaitent qu'on leur livre les circuits sous forme de bandes souples continues (en rouleaux) portant les circuits intégrés.

De cette manière ces utilisateurs peuvent plus facilement automatiser le montage de ces circuits intégrés sur des plaques de circuits imprimés ou sur d'autres supports. Ceci s'applique notamment dans le cas de circuits intégrés destinés à être montés en surface ; le montage de composants en surface est un type de montage beaucoup plus facilement automatisable que le montage des composants par insertion dans des trous percés dans les plaques imprimées.

Les machines de montage en surface reçoivent, comme source d'approvisionnement en composants, des bandes enroulées portant les composants, ces bandes étant entraînées pas à pas à la manière d'une bobine cinématographique. Ce n'est qu'au moment du montage sur un circuit imprimé qu'un composant individuel est séparé du reste de la bande.

Pour produire des bandes de circuits intégrés, on a prévu essentiellement deux types de fabrication.

Le premier consiste à utiliser comme bande de support une grille métallique découpée (grille de cuivre par exemple) qui comporte, pour chaque emplacement de composant, d'une part une embase pour recevoir une puce de circuit intégré et d'autre part des conducteurs individuels servant de broches de connexion extérieures pour le circuit intégré. Pour conserver une tenue mécanique suffisante de la grille, les conducteurs constituant les broches extérieures sont reliés les uns aux autres par des éléments de la grille et ils sont donc court-circuités les uns par rapport aux autres. Ce n'est qu'au moment du détachement d'un composant individuel en vue de son montage que l'on décourt circuite les broches en sectionnant les éléments qui relient les conducteurs entre eux.

Le second type de fabrication consiste à utiliser comme bande de support un film diélectrique (en général un polyimide) sur lequel est formé un motif de conducteurs en film mince, conducteurs qui, là encore, serviront de broches extérieures pour le composant lors de son montage sur un circuit imprimé. Les conducteurs sont imprimés sur le film diélectrique ; c'est donc le film diélectrique qui assure leur tenue mécanique, même si par endroits ce film comporte des ouvertures au-dessus desquelles passent les conducteurs. Il n'est pas nécessaire de prévoir d'éléments de liaison entre les différents conducteurs pour assurer la rigidité mécanique de ceux-ci.

Deux problèmes majeurs se posent en pratique. Le premier problème est celui du test des circuits intégrés, le deuxième est celui de leur protection.

En ce qui concerne le test, les bandes constituées à partir d'une grille métallique découpée rendent à priori impossible le test des circuits tant qu'ils sont sur bande puisque leurs broches sont toutes court-circuitées jusqu'à la séparation en composants individuels ; le test peut se faire sur la puce de circuit intégré avant qu'elle ne soit fixée sur la grille et connectée aux conducteurs de cette grille (test sur tranche) ; il peut se faire aussi après détachement d'un composant individuel au moment du montage sur un circuit imprimé, mais c'est trop tard car on préfère livrer à l'utilisateur des rouleaux de composants déjà testés.

C'est d'ailleurs une des raisons pour lesquelles on a éprouvé le besoin de monter les circuits intégrés sur des films diélectriques, car alors les broches ne sont pas court-circuitées et les circuits peuvent être testés sur la bande.

En ce qui concerne le problème de la protection des circuits intégrés, on sait qu'ils sont chimiquement et mécaniquement très fragiles et il est évidemment hors de question de livrer à un utilisateur une bande de circuits intégrés dans laquelle les puces de circuit ne seraient pas protégés d'une manière ou d'une autre contre les chocs mécaniques, contre les agents de corrosion et éventuellement contre les radiations électromagnétiques.

Pour les bandes constituées à partir d'une grille conductrice, cela ne pose pas de problème, la protection se fait par encapsulation dans un boitier de résine thermodurcissable ; la technique est celle qui est couramment utilisée pour la réalisation de circuits intégrés en boitier plastique ; cette technique est celle du moulage par transfert consistant à placer dans un moule la grille portant les puces, et à injecter une résine thermodurcissable autour de l'ensemble.

L'expérience montre que cette technique de protection, telle qu'elle est employée classiquement pour l'encapsulation de circuits intégrés en boitier plastique ne se prête pas du tout à l'encapsulation de circuits montés sur ruban diélectrique. En effet, la résine thermodurcissable est injectée à une température élevée et vient déformer le ruban diélectrique d'une manière irréversible ; le ruban déformé n'est pas satisfaisant du point de vue de l'apparence et il se prête mal à un enroulement en bobine serrée.

Pour protéger les circuits intégrés montés sur ruban diélectrique, on a alors recours à une technique plus simple que le moulage par transfert : on dépose sur la puce une goutte d'une résine polymérisable qui vient enrober la puce et les extrémités des conducteurs imprimés reliés à la puce. Mais la protection mécanique et la protection contre les radiations sont bien inférieures à celles que l'on peut obtenir par une résine thermodurcissable. Parfois même certaines parties de la puce restent dénudées (face arrière, cotés). De plus, le dépôt d'une goutte de résine ne permet absolument pas de former un composant ayant des dimensions calibrées comme c'est le cas pour les boitiers moulés ; la résine est sans forme, elle s'étale plus ou moins, la quantité globale déposée est variable etc...

Pour concilier les impératifs contradictoires de test et de qualité de protection, l'un conduisant à choisir un ruban diélectrique avec conducteurs imprimés et l'autre conduisant à choisir un ruban métallique découpé, il a déjà été proposé une solution complexe et coûteuse qui est la suivante : on utilise une grille métallique, et, lors de l'opération de moulage d'une résine thermodurcissable, on réalise non seulement un boitier de plastique enrobant la puce de circuit intégré et laissant dépasser des broches de connexion extérieures court-circuitées par des barres de liaison, mais aussi un anneau périphérique de matière plastique autour du boitier ; les broches de connexion extérieures s'étendent alors entre le boitier et l'anneau périphérique ; elles sont rigidement maintenues par le boitier d'un côté, par l'anneau de l'autre, et elles peuvent alors être décourt-circuitées par sectionnement des barres de liaison sans que la tenue mécanique du ruban en soit affectée ; à l'extérieur de l'anneau périphérique, des plots de test reliés aux broches de connexion sont maintenus en place par l'anneau. Le test individuel des composants est facilité grâce à ces plots ; toutefois, ce test n'est possible qu'après séparation des composants en éléments individuels et non tant qu'ils sont en bande. La protection est de bonne qualité puisqu'elle est faite par moulage d'une résine thermodurcissable.

L'inconvénient de cette solution est son coût élevé car les moules à utiliser sont complexes, et l'encombrement résultant de l'utilisation d'un anneau périphérique est particulièrement important. De plus, le test sur bande n'est pas possible.

L'invention part de la constatation expérimentale que la déformation du ruban diélectrique qui rend a priori inutilisable le moulage par transfert d'une résine thermodurcissable peut être évitée en utilisant une opération de moulage différente de celle qui est habituellement utilisée.

Dans les techniques connues d'encapsulation des circuits intégrés en résine thermodurcissable, on utilise toujours un moulage entre deux plaques de moulage séparables que l'on ferme après avoir placé entre ces plaques la grille conductrice portant les puces ; l'injection de résine thermodurcissable se fait par le plan de joint entre les deux plaques de moulage. Cela permet de nettoyer facilement les plaques de moulage et l'orifice d'injection de résine après que le moulage ait été effectué et qu'on ait retiré du moule la bande de composants encapsulés.

La présente invention telle que revendiquée propose d'effectuer un moulage dit moulage en pointe, qui est utilisé habituellement pour mouler des résines thermoplastiques plutôt que des résines thermodurcissables mais que l'on va utiliser ici avec une résine thermodurcissable. Le moulage en pointe consiste à injecter la résine, dans la cavité de moulage formée entre les plaques de moulage, par un orifice qui n'est pas situé dans le plan de joint entre des plaques de moulage.

On constate que ce type de moulage élimine les difficultés rencontrées avec un moulage de type classique.

Il faut bien comprendre que si les résines thermodurcissables sont habituellement injectées à travers le plan de joint, c'est parce que ces résines se solidifient de manière irréversible en refroidissant et que l'injection par un orifice qui ne s'ouvre pas avec le moule rend beaucoup plus difficile le nettoyage de l'orifice après chaque opération de moulage. Au contraire les résines thermoplastiques peuvent être injectées à travers un orifice qui ne s'ouvre pas avec les plaques de moulage car même si la résine durcit en refroidissant, elle fond à nouveau en se réchauffant. Ici, on va utiliser un moulage en pointe, par un orifice qui ne s'ouvre pas avec le moule, mais avec une résine thermodurcissable.

Ainsi, au lieu de rester sur l'idée que la résine thermodurcissable est à une température trop élevée pour pouvoir être utilisée sans dommage pour le ruban diélectrique portant les circuits intégrés, la présente invention propose d'injecter cette même résine, à la même température, mais d'une manière qui est inhabituelle pour les circuits intégrés et qui n'est a priori pas souhaitable pour des résines thermodurcissables.

D'autres caractéristiques et avantages de l'invention apparaitront à la lecture de la description détaillée qui suit et qui est faite en référence aux dessins annexés dans lesquels :

- la figure 1 représente une vue en perspective d'un ruban diélectrique portant des conducteurs imprimés,
- la figure 2 représente schématiquement une coupe agrandie de ce ruban au niveau d'une puce,
- les figures 3, 4, 5, 6 représentent des variantes de modes d'encapsulation de la technique antérieure,
- la figure 7 représente, en vue latérale, une bande de composants encapsulés selon la présente invention,

- la figure 8 représente schématiquement la constitution du moule permettant cette encapsulation,
- la figure 9 représente une variante de réalisation du moule.

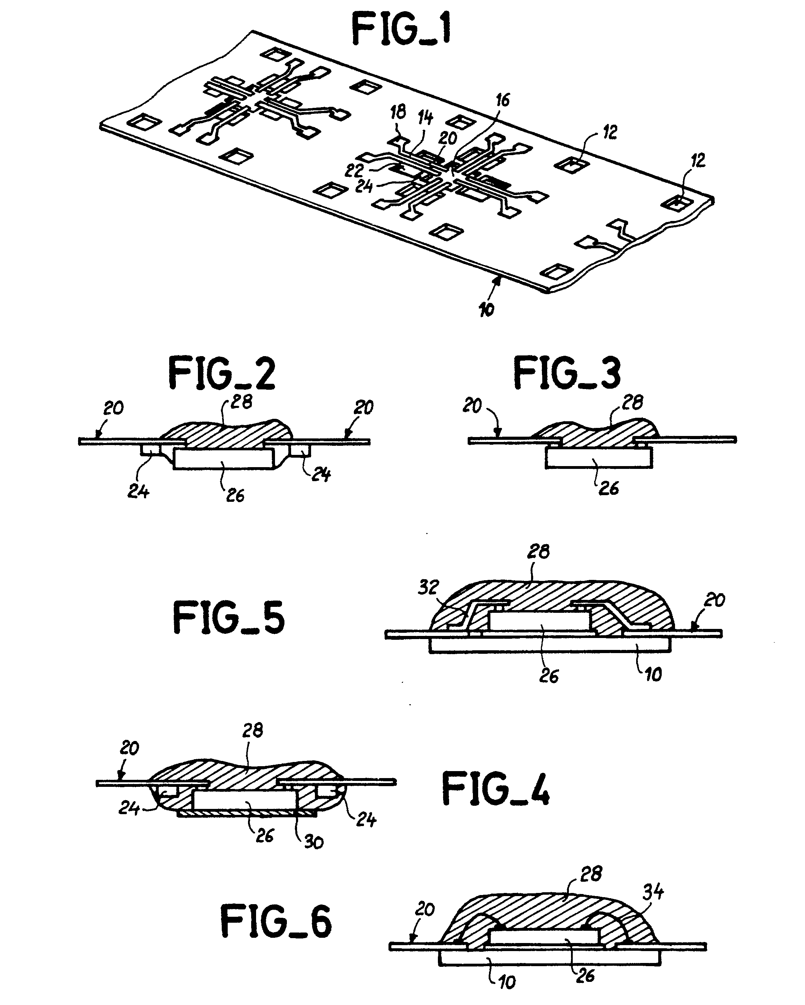

Sur la figure 1 on reconnaitra un ruban continu 10 de matière diélectrique souple destiné à supporter des circuits intégrés et à être enroulé pour être livré sous forme de rouleaux à un utilisateur.

Le ruban 10 est par exemple en polyimide d'une épaisseur d'environ 0,125 millimètre.

Il comporte des perforations latérales 12 telles que celles que l'on trouve sur les bords des films cinématographiques. Ces performations sont destinées à permettre l'avance automatique en continu ou pas à pas du ruban 10, aussi bien lors de la fabrication des bandes portant les circuits intégrés que lors de l'utilisation de ces bandes pour l'approvisionnement en composants d'une machine de montage de composants sur des plaques de circuit imprimé. Le ruban 10 comporte aussi d'autres perforations dont on expliquera le rôle plus loin.

Le ruban 10 comporte par ailleurs des conducteurs électriques 14 en film mince imprimés à la surface supérieure du ruban. Par conducteurs imprimés on entend des conducteurs formés selon un motif déterminé, que ce soit par photogravure ou par tout autre moyen, et qui adhèrent à la surface du ruban.

Ces conducteurs sont adhérents à la surface du film diélectrique mais à certains endroits ils se prolongent au-dessus de perforations formées dans le ruban diélectrique ; à ces endroits, la rigidité naturelle du film conducteur permet de passer au-dessus des perforations sans rupture des conducteurs (l'épaisseur du film conducteur est choisie en conséquence).

Le motif de conducteurs 14 et le motif de perforations au-dessus desquelles passent ces conducteurs se répète à intervalles réguliers le long de la bande 10, chaque motif correspondant à l'emplacement d'un circuit intégré à monter sur la bande.

Les conducteurs 14 sont bien individualisés, ils ne sont pas court-circuités les uns avec les autres comme c'est le cas dans les bandes formées à partir d'une grille métallique découpée.

Chaque conducteur comprend essentiellement trois parties :

- une extrémité intérieure, du côté du centre du motif de conducteurs ; cette extrémité est destinée à être connectée à un plot de contact respectif prévu sur une puce de circuit intégré qui sera placée au centre du motif ; l'extrémité intérieure est en porte-à-faux au-dessus d'une perforation centrale 16 formée dans le ruban 10 au centre du motif, la puce de circuit intégrée étant placée dans cette perforation centrale, en principe du côté de la face arrière du ruban (si on prend comme face avant la face portant les conducteurs imprimés).

- une extrémité extérieure adhérente au ruban diélectrique et comportant de préférence un plot 18 dit plot de test par lequel on pourra appliquer ou recueillir des signaux électriques en vue du test du circuit après sa fixation sur la bande.
- une partie centrale 20 passant au-dessus d'une perforation périphérique 22 formée dans le ruban. Cette partie centrale est celle qui servira de broche de connexion extérieure pour le circuit intégré lorsqu'il sera encapsulé.

Dans l'exemple qui est représenté sur la figure 1, la perforation centrale 16 et les perforations périphériques 22 sont séparées par des ponts 24 de matière diélectrique du ruban. Ces ponts 24 servent à améliorer la tenue mécanique des conducteurs 14 qui adhèrent au diélectrique à la fois du côté extérieur (du côté des plots de test, au delà de la perforation périphérique 22) et du côté intérieur (sur le pont 24 du côté de l'extrémité intérieure des conducteurs).

Dans certains cas, pour des petits circuits, on peut prévoir que la perforation centrale 16 et les perforations périphériques 22 sont réunies en une seule et même perforation, les conducteurs 14 n'étant alors soutenus que d'un seul côté et étant en porte à faux sur toute la longueur correspondant à la partie centrale et à l'extrémité intérieure. On conçoit que cette disposition n'est possible que si cette longueur n'est pas trop grande.

Dans la technique antérieure, la fabrication de la bande de composants consistait d'abord à connecter électriquement les extrémités intérieures des conducteurs à une puce de circuit intégré mise en place au centre du motif de conducteurs ; cette connexion se fait par exemple par soudage direct des extrémités de conducteurs sur les différents plots de contacts prévus sur la puce ; le soudage est en principe un soudage par thermocompression ; puis on dépose une goutte de résine de protection polymérisable (résine époxy) sur la face supérieure de la puce (celle qui comporte les plots de contact) ; cette goutte de résine enrobe plus ou moins bien les côtés et en général pas du tout la face arrière de la puce.

Après polymérisation de la résine la bande de composants est prête ; les composants individuels peuvent être testés grâce aux plots de test 18 correspondant à chacun des conducteurs de connexion extérieure du circuit intégré.

L'utilisateur qui reçoit la bande n'a plus à effectuer qu'une opération de découpage pour :

- séparer un circuit intégré du reste de la bande,
- découper le ruban diélectrique autour du circuit encapsulé, et découper les conducteurs 14 entre leur extrémité extérieure et leur partie centrale, de manière à obtenir un circuit encapsulé d'où sortent des broches extérieures de connexion constituées par la partie centrale 20 qui s'étendait auparavant au-dessus d'une perforation périphérique 22.

Les figures 2, 3, 4, 5 et 6 montrent schématiquement en coupe diverses structures ainsi obtenue ; les références sont les mêmes qu'à la figure 1, la puce est désignée par 26, la résine polymérisable par 28.

La figure 2 correspond au cas où des ponts de ruban diélectrique 24 existent entre la perforation centrale 16 et les perforations périphériques 22.

La figure 3 correspond au cas où il n'y a qu'une perforation centrale et pas de perforation périphérique.

La figure 4 correspond au cas où on a placé à l'arrière de la puce, avant le dépôt de la goutte de résine, une feuille de protection arrière 30, par exemple en tissu de verre imprégné de résine époxy.

La figure 5 correspond au cas où les conducteurs formés sur le ruban diélectrique ne sont pas soudés directement sur les plots de contact de la puce, mais des pontets conducteurs 32 sont soudés entre les conducteurs imprimés 14 et les plots de contact de la puce.

La figure 6 correspond au cas où des fils 34 (d'or ou d'aluminium) sont soudés entre les conducteurs imprimés 14 et les plots de contact de la puce.

Dans le cas des figures 5 et 6, la perforation centrale du ruban diélectrique 10 devient inutile, seules les perforations périphériques subsistent ; les ponts 24 dessinés à la figure 1 occupent alors toute la place de la perforation centrale et la puce repose sur le ruban, éventuellement métallisé à l'emplacement de la puce.

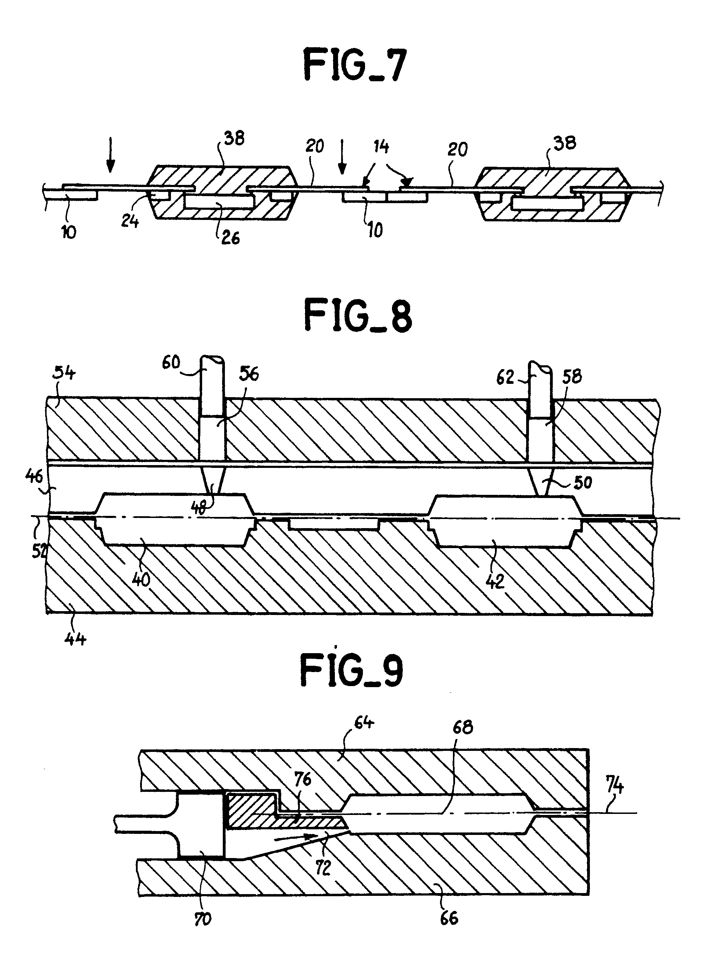

La figure 7 représente en coupe une bande de composants encapsulés selon l'invention.

Chaque composant est enrobé d'une résine thermodurcissable 38 obtenue par moulage par transfert autour du ruban diélectrique 10 portant les puces 26 et les conducteurs en couche mince.

La figure 8 représente en coupe schématique la structure du moule utilisé dans le procédé selon l'invention.

Ce moule comporte deux plaques mobiles délimitant entre elles lorsqu'elle sont appliquées l'une contre l'autre (moule fermé) les cavités de moulage correspondant à l'emplacement de chaque composant à enrober.

Sur la figure 8, le moule comporte deux cavités 40 et 42 permettant le moulage simultané des deux composants représentés à la figure 7.

Les plaques mobiles délimitant ces cavités sont respectivement une plaque inférieure 44 et une plaque dite plaque intermédiaire 46.

Dans la plaque intermédiaire 46 est prévue, aboutissant dans chacune des cavités, un orifice respectif d'injection de résine thermodurcissable, respectivement 48 pour la cavité 40 et 50 pour la cavité 42.

Cet orifice n'est pas placé dans le plan de fermeture des plaques 44 et 46, c'est-à-dire le plan qui contient le ruban 10 pendant l'opération de moulage (plan perpendiculaire à la feuille sur la figure 7 et s'étendant selon la ligne pointillée 52).

Au contraire, comme on le voit sur la figure 7, l'orifice d'injection de chaque cavité, est situé bien à l'écart du plan contenant le ruban 10.

La plaque intermédiaire 46 et la plaque inférieure 44 sont conformées, dans leurs surfaces en vis-à-vis l'une de l'autre, de manière à ne pas écraser les différentes partie du ruban diélectrique (ruban lui-même, ponts 24, conducteurs imprimés, puce 26 etc...) lorsque le moule se ferme.

Enfin le moule comporte une plaque supérieure 54 pourvue d'orifices (56 et 58) en regard des orifices d'injection respectifs (48 et 50) de la plaque intermédiaire, et pourvue de moyens d'injection de résine, symbolisés par des pistons respectifs 60 et 62 capables de refouler de la résine thermodurcissable liquide des orifices 56 et 58 de la plaque supérieure 54 vers les orifices 48 et 50 de la plaque intermédiaire et de là dans les cavités 40 et 42.

Les orifices de la plaque supérieure 54 sont de préférence cylindriques. Ceux de la plaque intermédiaire 46 sont de préférence coniques pour faciliter l'extraction des "carottes" de résine après une opération de moulage, c'est-à-dire l'extraction de résine durcie subsistant dans les orifices 48 et 50 après refroidissement du moule. On obtient grâce au procédé selon l'invention des composant bien protégés, encapsulés dans un boitier de dimension bien reproductibles, et ceci en permettant un stockage sur bande souple diélectrique autorisant le test individuel des composant sur bande.

Dans une autre réalisation, l'orifice d'injection n'est pas orienté verticalement, c'est-à-dire perpendiculairement au plan de fermeture des plaques, mais horizontalement, parallèlement au plan du ruban 10.

La figure 9 représente la configuration du moule, avec un tel orifice. Le moule comporte essentiellement une plaque supérieure 64 et une plaque inférieure 66 délimitant entre elles, lorsqu'elles sont fermées une cavité de moulage 68.

L'injection se fait par un piston (ou des pistons) horizontal 70 refoulant la résine thermodurcissable dans un orifice conique 72 de direction générale parallèle au plan de fermeture des plaques (plan désigné par la ligne tiretée 74). L'orifice 72 est cependant à l'écart de ce plan et est, dans cette réalisation, délimité d'un côté par la plaque inférieure 66 et de l'autre par une plaque intermédiaire 76 qui est en contact avec le film diélectrique 10 lorsqu'il est placé dans le moule et qui sépare donc ce film de l'orifice d'injection 72.

Le procédé selon l'invention est utilisable pour différentes configurations de conducteurs imprimés, de perforations du ruban, et de mode de connexion entre les conducteurs imprimés et la puce, et en particulier pour des configurations correspondant aux composants des figures 2 à 6.

## Revendications

1. Procédé d'encapsulation de circuits intégrés fixés sur un ruban diélectrique souple (10) portant des conducteurs électriques imprimés constituant les broches de connexion extérieures (20) des circuits intégrés, caractérisé en ce qu'il consiste à placer le ruban diélectrique à plat entre une première (44) et une seconde (46) plaques d'un moule, les deux plaques définissant entre elles, lorsqu'elles sont en contact avec le ruban, un plan de joint (52) dans lequel est placé le ruban et au moins une cavité (40) entourant un circuit intégré et entourant partiellement les conducteurs imprimés situés autour de ce circuit, la cavité étant pourvue d'un orifice (48) d'injection de résine situé en dehors du plan de joint, et à injecter une résine thermodurcissable dans la cavité par l'orifice.

2. Procédé d'encapsulation de circuits intégrés selon la revendication 1, caractérisé en ce que l'orifice est situé dans l'une des plaques (46).

3. Procédé d'encapsulation de circuits intégrés selon la revendication 1, caractérisé en ce que l'orifice est constitué entre l'une des plaques (66) et une plaque intermédiaire (76) séparant cet orifice du ruban diélectrique (10) lorsque celui-ci est placé dans le moule.

## Claims

1. A method for the encapsulation of integrated circuits fixed to a flexible dielectric strip (10) bearing printed electrical conductors constituting the external connection pins (20) of the integrated circuits, characterized in this that the dielectric strip is laid flat between a first plate (44) and a second plate (46) of a mold, the two plates demarcating between them, when they are in contact with the strip, a parting plane (52) in which the strip is placed and at least one cavity (40) surrounding an integrated circuit and partially surrounding the printed conductors located around this circuit, the cavity being provided with a resin-injection hole (48) located outside the parting plane, and characterized in this that a thermosetting resin is injected into the cavity through the hole.

2. A method For the encapsulation of integrated circuits according to claim 1, characterized in this that the hole is located in one of the plates (46).

3. A method For the encapsulation of integrated circuits according to claim 1, characterized in this that the hole is made between one of the plates (66) and an intermediate plate (76) that separates this hole from the dielectric strip (10) when the latter is placed in the mold.

## Ansprüche

1. Verkapselungsverfahren für integrierte Schaltungen, die auf einem flexiblen dielektrischen Band befestigt sind, welches gedruckte elektrische Leiter trägt, die die äußeren Anschlußpunkte der integrierten Schaltungen bilden, dadurch gekennzeichnet, daß das dielektrische Band flach zwischen eine erste und eine zweite Platte (44, 46) einer Spritzform plaziert wird, die, wenn sie in Kontakt mit dem Band sind, zwischen sich eine Trennebene (52) definieren, in der das Band und zumindest ein Hohlraum gelegen ist, der eine integrierte Schaltung sowie teilweise die gedruckten und um die integrierte Schaltung gelegenen Leiter umgibt und der außerhalb der Trennebene mit einer Injektionsöffnung (48) versehen ist, und daß ein hitzehärtbarer Kunststoff in den Hohlraum über die Injektionsöffnung eingespritzt wird.

2. Verkapselungsverfahren für integrierte Schaltungen nach Anspruch 1, dadurch gekennzeichnet, daß die Injektionsöffnung in einer der Platten (44, 46) gelegen ist.

3. Verkapselungsverfahren für integrierte Schaltungen nach Anspruch 1, dadurch gekennzeichnet, daß die Injektionsöffnung durch den Zwischenraum zwischen einer der Platten (66) und einer Zwischenplatte (76) gebildet ist, welche die Injektionsöffnung vom dielektrischen Band (10) trennt, wenn dieses in der Spritzform plaziert ist.

# FIG_1

# FIG_2

# FIG_3

# FIG_5

# FIG_4

# FIG_6

## FIG_7

## FIG_8

## FIG_9